# EUROPÄISCHE PATENTSCHRIFT

(11) **EP 2 907 208 B1**
(45) Veröffentlichungstag und Bekanntmachung des Hinweises auf die Patenterteilung: **01.07.2020**
(21) Anmeldenummer: 13780079.3
(22) Anmeldetag: 20.09.2013
(51) Int. Cl.: H02S 50/10, H02H 3/33, H01H 83/20, H02H 1/00, H01H 83/22, H02H 7/122

(54) **DIFFERENZSTROM-ÜBERWACHUNGSEINRICHTUNG MIT LICHTBOGENERKENNUNG**
DIFFERENTIAL CURRENT MONITORING DEVICE WITH ARC DETECTION
DISPOSITIF DE SURVEILLANCE DE COURANT DIFFÉRENTIEL À DÉTECTION D'ARC

(30) Priorität: 11.10.2012 DE 102012218504
(43) Veröffentlichungstag der Anmeldung: 19.08.2015
(73) Patentinhaber: Bender GmbH & Co. KG, 35305 Grünberg (DE); Ellenberger & Poensgen GmbH, 90518 Altdorf (DE)
(72) Erfinder: MÖLL, Winfried, 35321 Laubach (DE); SCHÄFER, Oliver, 35305 Grünberg (DE); SELLNER, Harald, 35305 Grünberg (DE); HÄUSLEIN, Bernd, 90411 Nürnberg (DE); KAMMER, Michael, 35410 Hungen (DE); DECKER, Timm, 58239 Schwerte (DE); STROBL, Christian, 90559 Burgthann (DE); WEBER, Waldemar, 90431 Nürnberg (DE); WIERSCH, Markus, 90518 Altdorf (DE); ZEBERL, Jürgen, 92283 Lauterhofen (DE)
(74) Vertreter: advotec.
(86) Internationale Anmeldenummer: PCT/EP2013/069639
(87) Internationale Veröffentlichungsnummer: WO 2014/056707

(56) Entgegenhaltungen:
- WO-A1-2004/047137
- US-A- 4 568 899
- US-A- 5 095 398
- US-A1- 2010 324 747

## Beschreibung

Die Erfindung betrifft eine Differenzstrom-Überwachungseinrichtung zur Überwachung von Differenzströmen in Stromversorgungssystemen, mit einem ersten Messstromwandler und mit einem Messkreis zur Bestimmung des Differenzstromes sowie mit einer Recheneinheit zur Auswertung des Differenzstromes und zur Erzeugung eines Abschaltsignals.

Differenzstrom-Überwachungseinrichtungen sind als Vorrichtungen zur galvanisch getrennten Strommessung für elektrische Anlagen bekannt. Die Aufgabe einer derartigen Differenzstrom-Überwachungseinrichtung ist es, elektrische Installationen oder Stromkreise auf das Auftreten eines Differenzstroms zu überwachen und durch einen Alarm anzuzeigen, wenn dieser einen festgelegten Wert überschreitet. Differenzstrom-Überwachungseinrichtungen üben im Gegensatz zu Fehlerstrom-Schutzeinrichtungen selbst keine direkt abschaltende Funktion aus, können aber über ein Melderelais zur Weitergabe von Alarmmeldungen verfügen und damit indirekt eine Abschaltung der Anlage bewirken. In der Regel werden zur Erkennung eines Differenzstromes alle aktiven Leiter der zu schützenden Leitung als Primärwicklung durch einen Messstromwandler(kern) geführt, der mit einer Sekundärwicklung ausgestattet ist. Im fehlerfreien Stromversorgungssystem ist die vektorielle Summe aller Ströme und damit der Differenzstrom gleich Null, so dass in der Sekundärwicklung keine Spannung induziert wird. Fließt hingegen ein Fehlerstrom, z.B. infolge eines Isolationsfehlers, über Erde ab, so fließt durch den Messstromwandler ein Differenzstrom, dessen Magnetfeld im Falle einer zeitlichen Änderung sekundärseitig eine Spannung induziert, die detektiert und ausgewertet werden kann.

Neben Fehlerströmen können in elektrischen Anlagen als weitere Störeffekte unerwünschte Gasentladungen (Plasmen) zwischen den elektrischen Leitern auftreten. Eine frühzeitige Erkennung derartiger Störlichtbögen kann daher helfen, Schäden an der Anlage zu vermeiden und schlimmstenfalls Brände zu verhüten. Zur Erkennung eines Lichtbogens ist es bekannt, den (Absolut-)Strom eines Leiters der Anlage auf Störkomponenten hin zu überwachen, die charakteristisch einem Lichtbogen zuzuordnen sind und sich beispielsweise durch eine spektrale Auswertung des Stroms feststellen lassen. Wird ein gefährlicher Lichtbogen erkannt, so wird ein Signal erzeugt, das die Anlage abschaltet oder kurzschließt, um den Lichtbogen zu löschen.

Insbesondere in Verbindung mit der Installation von Fotovoltaikanlagen rückt das Problem der Lichtbogenerkennung in den Mittelpunkt des Interesses, da spezielle elektrische Schutzanforderungen, u.a. hinsichtlich des Brandschutzes, eine umfassende elektrische Überwachung der Anlage erforderlich machen. Nach gesetzlicher Vorschrift werden Differenzstrom-Überwachungseinrichtungen als Teilmodul in die Wechselrichter der Fotovoltaikanlage integriert. Einrichtungen zur Lichtbogenerkennung hingegen unterliegen noch nicht einer derartigen gesetzlichen Vorschrift und stellen, sofern sie verbaut werden, dem Stand der Technik entsprechend separate Einheiten innerhalb eines Wechselrichters dar oder werden als eigenständige bauliche Einheit separat montiert. Damit gestaltet sich die Realisierung eines umfassenden Schutzkonzeptes wegen der Vielzahl unterschiedlicher Schutzeinrichtungen recht aufwändig.

Der vorliegenden Erfindung liegt somit die Aufgabe zu Grunde, im Sinne eines umfassenden elektrischen Schutzes von Stromversorgungssystemen eine Einrichtung zur Lichtbogenerkennung in die Schutztechnik miteinzubeziehen und das Zusammenwirken der Lichtbogenerkennungseinrichtung mit bekannten Schutzeinrichtungen zu vereinfachen sowie unter wirtschaftlichen Gesichtspunkten ein möglichst kostengünstiges Produkt herzustellen.

Diese Aufgabe wird für ein Stromversorgungssystem, welches ein Gleichspannungsnetz und ein über einen Wechselrichter damit verbundenes Wechselspannungsnetz umfasst, durch eine Differenzstrom-Überwachungseinrichtung nach Anspruch 1 gelöst.

Indem erfindungsgemäß die Einrichtung zur Lichtbogenerkennung funktional in die Differenzstrom-Überwachungseinrichtung integriert ist, kann der technische Aufwand zur Überwachung des Differenzstroms verbunden mit der Lichtbogenerkennung gegenüber einer funktional und räumlich getrennten Anordnung beider Schutzmaßnahmen erheblich gesenkt werden. Die schaltungstechnische Integration der Einrichtung zur Lichtbogenerkennung ermöglicht im Fehlerfall eine schnellere Reaktionszeit durch die gemeinsame Nutzung derselben Abschaltpfade. Zudem ergibt sich durch die funktionale und je nach Ausgestaltung auch räumliche Zusammenfassung von Funktionseinheiten zur Differenzstrom-Erkennung mit Einheiten zur Lichtbogenerkennung auch unter wirtschaftlichen Aspekten ein Kostenvorteil. Wesentliche mechanische und elektronische Bauelemente müssen nicht mehr doppelt ausgeführt werden. Der Einsatz "einer" Elektronik trägt damit erheblich zur Kostenreduktion bei.

In der erfindungsgemäßen Differenzstrom-Überwachungseinrichtung kann zudem neben der Überwachung von Differenzströmen eine parallele Auswertung des Absolutstromes durch die integrierte Lichtbogenerkennung durchgeführt werden.

Außerdem erlaubt die integrierte Anordnung, dass bei gleichzeitiger Erkennung eines Differenzstromes und eines Lichtbogens von einem parallelen Lichtbogen nach "Erde" ausgegangen werden kann, der je nach Betriebszustand der elektrischen Anlage nicht zu einer Abschaltung führen darf.

Erfindungsgemäß weist die Einrichtung zur Lichtbogenerkennung einen zweiten Messstromwandler, durch den ein aktiver Leiter des Stromversorgungssystems zur Erfassung eines Einzelleiterstromes geführt wird, und einen Messkreis zur Bestimmung des Einzelleiterstromes für eine Lichtbogenerkennung auf. Neben dem ersten Messstromwandler, der in Verbindung mit dem entsprechenden Messkreis der Bestimmung des Differenzstromes dient, weist die Differenzstrom-Überwachungseinrichtung somit einen zweiten Messstromwandler und einen weiteren Messkreis auf. Der zweite Messstromwandler umfasst einen Einzelleiter, so dass in Verbindung mit einem nachgeschalteten Messkreis der in diesem Leiter fließende Einzelleiterstrom erfasst und bestimmt werden kann.

Erfindungsgemäß ist der zweite Messstromwandler zur Lichtbogenerkennung als externer Stromwandler räumlich getrennt von dem Gehäuse der Differenzstrom-Überwachungseinrichtung angeordnet.

In dieser Ausführung der Differenzstrom-Überwachungseinrichtung mit integrierter Lichtbogenerkennung ist lediglich der Messstromwandler zur Erfassung des Einzelleiterstromes außerhalb eines gemeinsamen Gehäuses angeordnet. Die Auswertung und Bestimmung des Differenzstrom sowie des Einzelleiterstromes erfolgen zentral in einer baulichen Einheit.

Erfindungsgemäß umfasst der externe, zweite Messstromwandler zur Lichtbogenerkennung in dem Stromversorgungssystem mit einem Gleichspannungsnetz, mit einem Wechselrichter und mit einem Wechselspannungsnetz einen aktiven Leiter des Gleichspannungsnetzes.

In dieser vorteilhaft in Fotovoltaikanlagen einsetzbaren Ausführungsform ist der Messstromwandler zur Erfassung des Differenzstromes in dem Wechselspannungsnetz angeordnet, wohingegen der zweite Messstromwandler zur Erfassung des Absolutstromes für die Lichtbogenerkennung räumlich getrennt davon auf der Gleichspannungsseite der Fotovoltaikanlage installiert ist.

Erfindungsgemäß ist eine Recheneinheit zur Auswertung des Einzelleiterstromes mit der Recheneinheit zur Auswertung des Differenzstromes in einer gemeinsamen Recheneinheit in der Differenzstrom-Überwachungseinrichtung zusammengefasst.

Die Anordnung des Lichtbogenerkennungs-Messkreises in einem gemeinsamen Gehäuse mit der Differenzstrom-Überwachungseinrichtung führt zu einer kompakten Bauform, verbunden mit geringerem Montageaufwand. Ein separates Gehäuse zur Aufnahme der Messkreiselektronik für die Lichtbogenerkennung ist nicht mehr erforderlich. Auch können weitere Hardware-Komponenten gemeinsam und damit effektiver genutzt werden. So lässt sich beispielsweise eine Rechner-Hardware sowohl zur Ausführung von Software-Programmen für die Auswertung des Differenzstromes als auch zur Ausführung von Software-Programmen für die Auswertung des Einzelleiterstromes heranziehen.

Der erste Messstromwandler zur Erfassung eines Differenzstromes umfasst vorzugsweise alle aktiven Leiter einer zu schützenden Leitung des Wechselspannungsnetzes. Da der erste Messstromwandler auf der Wechselspannungsseite, der zweite Messstromwandler auf der Gleichspannungsseite der Fotovoltaikanlage angeordnet ist, ist es zweckmäßig, die Erfassung des Differenzstromes konventionell auszuführen, indem ein Wandlerkern alle aktiven Leiter der zu überwachenden Leitung des Wechselspannungsnetzes umschließt.

Weiterhin erzeugt die gemeinsame Recheneinheit der Differenzstrom-Überwachungseinrichtung ein Steuersignal, um das Stromversorgungssystem in einen sicheren Zustand zu versetzen. Um im Fehlerfall einen entstandenen Lichtbogen schnell löschen zu können, erzeugt die gemeinsame Recheneinheit in der erweiterten Differenzstrom-Überwachungseinrichtung ein Steuersignal, das das Stromversorgungssystem durch Trennen und/oder Kurzschließen und/oder durch eine Veränderung des Arbeitspunktes der elektrischen Anlage in einen sicheren Zustand überführt. Das Steuersignal kann beispielsweise ein Signal zur Ansteuerung des Wechselrichters sein, das diesen veranlasst, die Gleichspannungsseite der Fotovoltaikanlage kurzzuschließen.

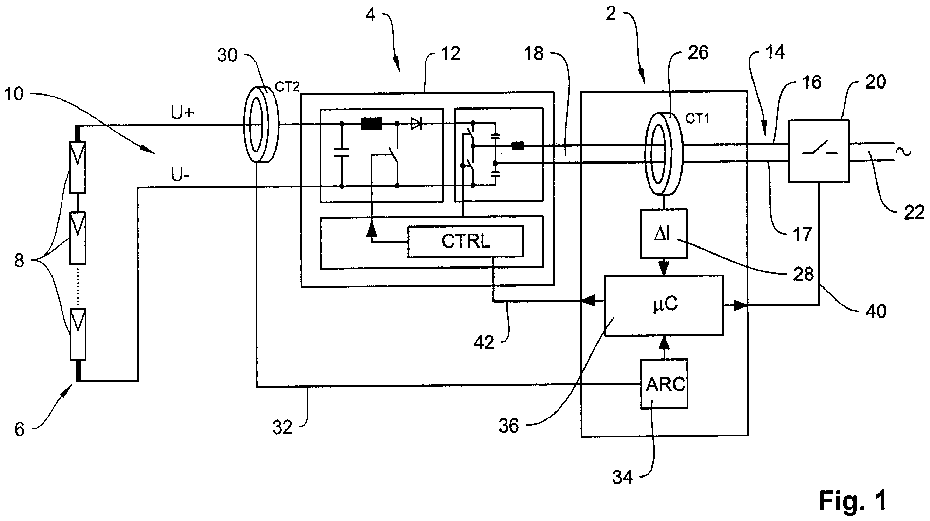

Weitere vorteilhafte Ausgestaltungsmerkmale ergeben sich aus der nachfolgenden Beschreibung und der Zeichnung, die eine bevorzugte Ausführungsform der Erfindung an Hand eines Beispiels erläutert. Es zeigt die
- Fig. 1:: eine Ausführungsform einer Differenzstrom-Überwachungseinrichtung für eine Fotovoltaikanlage.

Fig. 1 zeigt schematisch in vereinfachter Darstellung eine erfindungsgemäße Differenzstrom-Überwachungseinrichtung 2 in Verbindung mit der Überwachung einer Fotovoltaikanlage 4. Die Fotovoltaikanlage 4 ist generatorseitig durch einen Strang 6 von Solarstrommodulen 8 symbolisiert, der ein Gleichspannungsnetz 10 mit den Photovoltaikgleichspannungen U+ und U- erzeugt.

Die bei einer ausreichenden Bestrahlung der Solarstrommodule 8 erzeugten Photovoltaikgleichspannungen U+ und U- werden einem Wechselrichter 12 zugeführt. Dieser erzeugt in dem dargestellten Beispiel ausgangsseitig ein Wechselspannungsnetz 14 mit einer aus zwei aktiven Leitern 16, 17 bestehenden Leitung 18, die über eine Abschaltvorrichtung 20 an ein externes Stromversorgungsnetz 22 angekoppelt ist.

Die erfindungsgemäße Differenzstrom-Überwachungseinrichtung 2 weist einen ersten Messstromwandler 26 mit einem Messkreis 28 zur Erfassung und Bestimmung eines in der Leitung 18 auftretenden Differenzstromes auf. Dabei werden alle aktiven Leiter 16, 17 der zu überwachenden Leitung 18 durch den Messstromwandler 26 geführt.

Ein zweiter Messstromwandler 30 zur Lichtbogenerkennung ist als externer Stromwandler räumlich getrennt von dem Gehäuse der Differenzstrom-Überwachungseinrichtung 2 auf der Gleichspannungsseite der Fotovoltaikanlage angeordnet und umschließt dort einen aktiven Leiter des Gleichspannungsnetzes 10. Der zweite Messstromwandler 30 ist über eine Verbindungsleitung 32 (Remote-CT-Verbindung, CT-Current Transformer/Stromwandler) an einen Messkreis 34 zur Bestimmung des in dem aktiven Leiter des Gleichspannungsnetzes 10 fließenden Absolutstromes an die Differenzstrom-Überwachungseinrichtung 2 angeschlossen. In einer gemeinsamen Recheneinheit 36 der Differenzstrom-Überwachungseinrichtung 2 findet die Auswertung des Differenzstromes und des Absolutstromes statt. Bei einer Überschreitung eines Ansprechwertes des Differenzstromes oder bei Erkennung einer Stromstörung, die auf die Entstehung eines Lichtbogens schließen lässt, wird ein Abschaltsignal 40 erzeugt, das die Fotovoltaikanlage 4 mittels der Abschaltvorrichtung 20 von dem externen Stromversorgungsnetz 22 trennt. Des Weiteren ist eine Steuerleitung 42 vorgesehen, die von der gemeinsamen Recheneinheit 36 der Differenzstrom-Überwachungseinrichtung 2 zu dem Wechselrichter 12 führt, der im Fehlerfall die Fotovoltaikanlage 4 zum Löschen des Lichtbogens kurzschließt.

## Patentansprüche

1. Differenzstrom-Überwachungseinrichtung (2) zur Überwachung von Differenzströmen in einem Stromversorgungssystem (4, 10, 14), welches ein Gleichspannungsnetz (10) und ein Wechselspannungsnetz (14) jeweils mit aktiven Leitern umfasst und das Gleichspannungsnetz (10) mit dem Wechselspannungsnetz (14) durch einen Wechselrichter (12) verbunden ist; die Differenzstrom-Überwachungseinrichtung (2) dabei umfassend
einen ersten Messstromwandler (26) und einen Messkreis (28), welche geeignet sind, den Differenzstrom in den aktiven Leitern (16, 17) des Wechselspannungsnetzes (14) zu bestimmen, sowie eine Recheneinheit (36) zur Auswertung des Differenzstromes und zur Erzeugung eines Abschaltsignals (40),
eine Einrichtung zur Lichtbogenerkennung mit einem zweiten Messstromwandler (30) und einen Messkreis (34), welche geeignet sind, den Einzelleiterstrom in dem aktiven Leiter des Gleichspannungsnetzes (10) für eine Lichtbogenerkennung zu bestimmen, und eine Recheneinheit zur Auswertung des Einzelleiterstromes mit der Recheneinheit (36) zur Auswertung des Differenzstromes in einer gemeinsamen Recheneinheit (36) zusammengefasst ist, wobei die Differenzstrom-Überwachungseinrichtung (2) ein Gehäuse zur Aufnahme der Komponenten zur Überwachung von Differenzströmen aufweist und der zweite Messstromwandler (30) als externer Stromwandler räumlich getrennt außerhalb von dem Gehäuse angeordnet ist. (2) zusammengefasst ist.

2. Differenzstrom-Überwachungseinrichtung nach Anspruch 1,
**dadurch gekennzeichnet,**
**dass** der erste Messstromwandler (26) zur Erfassung eines Differenzstromes alle aktiven Leiter (16, 17) des Wechselspannungsnetzes (14) umfasst.

3. Differenzstrom-Überwachungseinrichtung nach Anspruch oder 2,
**dadurch gekennzeichnet,**
**dass** die gemeinsame Recheneinheit (36) der Differenzstrom-Überwachungseinrichtung (2) ein Steuersignal erzeugt, um das Stromversorgungssystem (4, 10, 14) in einen sicheren Zustand zu versetzen.

## Claims

1. A differential current monitoring device (2) for monitoring differential currents in power supply systems (4, 10, 14) comprising a direct-voltage network (10) and an alternating-voltage network (14) each having active conductors, and the direct-voltage network (10) being connected to the alternating-voltage network (14) via an inverter (12); the differential current monitoring device (2) comprising a first measuring current transformer (26) and a measuring circuit (28), which are both suitable for determining the differential current in the active conductors (16, 17) of the alternating-voltage network (14), and comprising a computing unit (36) for evaluating the differential current and for generating a switch-off signal (40), a device for arc detection having a second measuring current transformer (30) and a measuring circuit (34), which are both suitable for determining the individual conductor current in the active conductor of the direct-voltage network (10) for the purpose of arc detection, and a computing unit for evaluating the individual conductor current being combined with the computing unit (36) for evaluating the differential current in a shared computing unit (36), the differential current monitoring device (2) comprising a housing for receiving the components for monitoring differential currents and the second measuring current transformer (30) being disposed as an external current transformer in a spatially separate manner from the housing.

2. The differential current monitoring device according to claim 1, **characterized in that**
the first measuring current transformer (26) for detecting a differential current comprises all active conductors (16, 17) of the alternating-voltage network (14).

3. The differential current monitoring device according to claim 1 or 2, **characterized in that**
the shared computing unit (36) of the differential current monitoring device (2) generates a control signal to transfer the power supply system (4, 10, 14) into a safe state.

## Revendications

1. Dispositif de surveillance à courant différentiel (2) pour surveiller des courants différentiels dans des systèmes d'alimentation (4, 10, 14) qui comprend un réseau de tension continue (10) et un réseau de tension alternative (14) ayant chacun des conducteurs actifs, et le réseau de tension continue (10) étant relié au réseau de tension alternative (14) par un onduleur (12); le dispositif de surveillance à courant différentiel comprenant un premier transformateur de courant de mesure (26) et un circuit de mesure (28) qui sont tous les deux aptes à déterminer le courant différentiel dans les conducteurs actifs (16, 17) du réseau de tension alternative (14) et comprenant une unité de compte (36) destinée à évaluer le courant différentiel et à générer un signal de coupure (40), un dispositif destiné à détecter des arcs électriques ayant un deuxième transformateur de courant de mesure (30) et un circuit de mesure (34) qui sont tous les deux aptes à déterminer le courant de conducteur individuel dans le conducteur actif du réseau de tension continue (10) afin de détecter des arcs électriques, et une unité de compte destinée à évaluer le courant de conducteur individuel et l'unité de compte (36) destinée à évaluer le courant différentiel étant rassemblées en une unité de compte (36) commune, le dispositif de surveillance à courant différentiel (2) comprenant une boîte destinée à recevoir les composants pour surveiller des courants différentiels et le deuxième transformateur de courant de mesure (30) étant disposé comme transformateur de courant extérieur dans une manière séparée spatialement de la boîte.

2. Dispositif de surveillance à courant différentiel selon la revendication 1,
**caractérisé en ce que**
le premier transformateur de courant de mesure (26) destiné à detecter un courant différentiel comprend tous conducteurs actifs (16, 17) du réseau de tension alternative (14).

3. Dispositif de surveillance à courant différentiel selon la revendication 1 ou 2,
**caractérisé en ce que**
l'unité de compte (36) commune du dispositif de surveillance à courant différentiel (2) génère un signal de contrôle afin de transférer le système d'alimentation (4, 10, 14) dans un état sécurisé.
